# EUROPÄISCHE PATENTSCHRIFT

(11) **EP 3 912 852 B1**
(45) Veröffentlichungstag und Bekanntmachung des Hinweises auf die Patenterteilung: **06.05.2026**
(21) Anmeldenummer: 21161919.2
(22) Anmeldetag: 11.03.2021
(51) Int. Cl.: B60L 58/16, G01R 31/3828, G01R 31/3832, G01R 31/387, G01R 31/388, H02J 7/00, B60L 58/12

(54) **VERFAHREN UND PRÜFSYSTEM ZUM PRÜFEN EINES ZUSTANDS EINER BATTERIE IN EINEM FAHRZEUG**
METHOD AND SYSTEM FOR TESTING A STATE OF A BATTERY IN A VEHICLE
PROCÉDÉ ET SYSTÈME D'ESSAI PERMETTANT DE CONTRÔLER L'ÉTAT D'UNE BATTERIE DANS UN VÉHICULE

(30) Priorität: 19.05.2020 DE 102020206260
(43) Veröffentlichungstag der Anmeldung: 24.11.2021
(73) Patentinhaber: VOLKSWAGEN AG, 38440 Wolfsburg (DE)
(72) Erfinder: Stichowski, Torsten, 39128 Magdeburg (DE); Borngräber, Dr. Ralf, 38165 Lehre (DE)

(56) Entgegenhaltungen:
- EP-A1- 3 106 892
- EP-A1- 3 640 071
- WO-A1-2013/156621
- CN-A- 107 817 449
- DE-A1- 102013 219 100
- DE-A1- 102017 208 394
- DE-A1- 102017 218 211
- DE-A1- 102018 207 055
- US-A1- 2016 356 856
- US-A1- 2019 334 213
- AVILOO: "Facebook", 2 April 2020 (2020-04-02), XP055832668, Retrieved from the Internet <URL:https://www.facebook.com/Aviloobatterydiagnostic/> [retrieved on 20210817]
- DERBRUTKASTEN: "Live von der Preisverleihung riz up, die Gr�nderagentur des Landes Nieder�sterreich-GENIUS mit den Gewinnern und Teilnehmern in den Kategorien Genial Startup / UnternehmerInnen / F&E / Digital, der Landesr�tin Petra Bohuslav und RIZ-Up CEO Petra Patzelt!", 28 May 2019 (2019-05-28), pages 1, XP054982146, Retrieved from the Internet <URL:https://fb.watch/7rI8LHQAKz/> [retrieved on 20210818]
- MAGR: "Das Ende der Batteriel�gen", 18 April 2019 (2019-04-18), XP055832663, Retrieved from the Internet <URL:https://scontent-ams4-1.xx.fbcdn.net/v/t1.6435-9/57987741_282890625974397_3519660862245699584_n.jpg?_nc_cat=104&ccb=1-5&_nc_sid=730e14&_nc_ohc=bUB9W-wiAoYAX_MABVz&_nc_ht=scontent-ams4-1.xx&oh=e675adc7144cddc92d939e3d1b2bf334&oe=61421766> [retrieved on 20210817]
- ANONYMOUS: "Aviloo: "Niemand kann dir sagen, wie gut die Batterie eines Elektroautos ist"", 16 December 2019 (2019-12-16), XP055832661, Retrieved from the Internet <URL:https://www.trendingtopics.at/aviloo-niemand-kann-dir-sagen-wie-gut-die-batterie-eines-elektroautos-ist/?fbclid=IwAR2xC2f0qSvZqg9Hw0LoGcxqRvrGD00RMj83990g41JJzccv5AHRFgGRFbA> [retrieved on 20210817]
- MRAZEK: "Die Akku-Fl�sterer", 24 August 2019 (2019-08-24), XP055832662, Retrieved from the Internet <URL:https://scontent-amt2-1.xx.fbcdn.net/v/t1.6435-9/69622703_364068744523251_5805182525756145664_n.jpg?_nc_cat=111&ccb=1-5&_nc_sid=730e14&_nc_ohc=Hm3mcDaRjuAAX-80xbZ&_nc_ht=scontent-amt2-1.xx&oh=5b5a089a9186937bbf0284d3aa2345a2&oe=614185DF> [retrieved on 20210817]
- BURGSTALLER: "Lade-H�ter", 31 March 2020 (2020-03-31), XP055832665, Retrieved from the Internet <URL:https://scontent-ams4-1.xx.fbcdn.net/v/t1.6435-9/91521223_530889017841222_2229074089455124480_n.jpg?_nc_cat=100&ccb=1-5&_nc_sid=730e14&_nc_ohc=6vHBQ520cpoAX_NILcq&_nc_ht=scontent-ams4-1.xx&oh=56b72827a2ffb146118ca5fb6c7e1d14&oe=61414442> [retrieved on 20210817]
- ANONYMOUS: "Gebrauchtwagen: Was beim Kauf eines gebrauchten Elektroautos wichtig ist - Golem.de", 5 February 2020 (2020-02-05), XP055832660, Retrieved from the Internet <URL:https://www.golem.de/news/elektromobilitaet-was-beim-kauf-eines-gebrauchten-elektroautos-wichtig-ist-2002-146389.html> [retrieved on 20210817]
- ANONYMOUS: "Volkswagen's Incubator programme: six start-ups move into the Gl�serne Manufaktur", 16 May 2019 (2019-05-16), XP093017803, Retrieved from the Internet <URL:https://www.volkswagenag.com/en/news/2019/05/volkswagen_dresden_six_start_ups.html#> [retrieved on 20230125]
- AVILOO: "Aviloo Battery Diagnostics", 2 October 2019 (2019-10-02), pages 1 - 24, XP093018102, Retrieved from the Internet <URL:https://www.facebook.com/Aviloobatterydiagnostic/> [retrieved on 20210819]
- AVILOO: "Aviloo battery diagnostic", 2 October 2019 (2019-10-02), https://www.facebook.com/Aviloobatterydiagnostic/, XP093018116, Retrieved from the Internet <URL:https://www.facebook.com/Aviloobatterydiagnostic/> [retrieved on 20230126]

## Beschreibung

Die vorgestellte Erfindung betrifft ein Verfahren und Prüfsystem zum Prüfen eines Zustands einer Batterie in einem Fahrzeug.

Batterien, insbesondere Traktionsbatterien zum Versorgen eines Antriebs eines Fahrzeugs sind von großem monetären Wert. Da Batterien je nach Verwendungsdauer und Verwendungsart einem unterschiedlichen Verschleiß unterliegen, unterscheidet sich ein Zustand verschiedener gebrauchter Batterien bei gleicher Laufleistung eines Fahrzeugs teilweise erheblich.

Ein Nutzer eines Fahrzeugs kann anhand von Betriebsparametern des Fahrzeugs, wie bspw. dessen Laufleistung, nur bedingt Erkenntnisse über einen Zustand von einer Batterie des Fahrzeugs gewinnen.

Da ein Zustand einer Batterie für einen Nutzer nicht direkt wahrnehmbar bzw. prüfbar ist, können Informationen über einen Zustand einer Batterie leicht gefälscht werden. Insbesondere können in einem Speicher abgelegte Werte eines Prüfverfahrens leicht überschrieben bzw. manipuliert werden.

Zum Beurteilen eines Zustands einer Batterie beschreibt die DE 101 2018 206 414 A1 ein Verfahren zum Ermitteln eines Zählwerts zum Zählen einer bisherigen effektiven Lebensdauer der Batterie.

Die US 2012/0316813 A1 beschreibt ein Verfahren zum Beurteilen eines Zustands einer Batterie, bei dem eine Menge von durch die Batterie bereits bereitgestellter Energie und/oder ein Schätzer einer verbleibenden Lebenszeit der Batterie anhand von Eigenschaften der Batterie ermittelt wird.

Die DE 10 2018 201 138 A1 beschreibt ein Verfahren zum Ermitteln von Abnutzungswerten für Elektrofahrzeuge, bei dem eine seit einer Erstinbetriebnahme zurückgelegte Distanz und eine Anzahl von Ladevorgängen zu einem Abnutzungsindikator zusammengefasst werden.

Darüber hinaus behandelt die folgende Website ein ähnliches Thema: https://www.facebook.com/ Aviloobatterydiagnostic/, siehe z.B. XP093018102, XP055832665.

Vor diesem Hintergrund ist es eine Aufgabe der vorgestellten Erfindung, einem Nutzer eines Fahrzeugs eine Möglichkeit zur vertrauenswerten bzw. fälschungssicheren Prüfung eines Zustands einer Batterie in einem Fahrzeug bereitzustellen.

Die voranstehend genannte Aufgabe wird gelöst durch ein Verfahren und ein Prüfsystem gemäß den jeweiligen unabhängigen Ansprüchen. In der Beschreibung, den Zeichnungen und den abhängigen Ansprüchen sind bevorzugte Weiterbildungen der Erfindung aufgeführt. Merkmale, die zu den einzelnen Erfindungsaspekten offenbart werden, können in der Weise miteinander kombiniert werden, dass bzgl. der Offenbarung zu den Erfindungsaspekten der Erfindung stets wechselseitig Bezug genommen wird bzw. werden kann.

Gemäß einem ersten Aspekt der vorgestellten Erfindung wird zur Lösung der voranstehend genannten Aufgabe ein Verfahren zum Prüfen eines Zustands einer Batterie in einem Fahrzeug vorgestellt. Das Verfahren umfasst einen Entladeschritt zum Entladen der Batterie bis zu einem vorgegebenen Ladezustand, einen Ladeschritt zum Laden der Batterie mit einem vorgegebenen Ladestrom bis die Batterie vollständig geladen ist, einen Ermittlungsschritt zum Ermitteln einer Gesamtkapazität der Batterie anhand einer Ladezeit und des Ladestroms, einen Zertifizierungsschritt zum Erstellen eines signierten Zertifikats, das die Gesamtkapazität beschreibt, einen Sicherungsschritt zum Sichern des Zertifikats in einem Speicher und einen Ausgabeschritt zum Ausgeben des Zertifikats auf einer Ausgabeeinheit.

Unter einem Zustand einer Batterie ist im Kontext der vorgestellten Erfindung eine Eignung zur Ausübung einer Funktion der Batterie, also zum Speichern und Abgeben von Elektrizität zu verstehen.

Unter einem Zertifikat ist im Kontext der vorgestellten Erfindung ein digitaler Datensatz zu verstehen, der bestimmte Eigenschaften eines digitalen Objekts bestätigt und dessen Authentizität und Integrität durch kryptografische Verfahren geprüft werden kann.

Die vorgestellte Erfindung basiert auf einem standardisierten Ladeprozess zum Bestimmen einer Gesamtkapazität einer Batterie. Der standardisierte Ladeprozess umfasst ein vollständiges Entladen, d.h. ein Entladen bis zu einem vorgegebenen Ladezustand und ein anschließendes Aufladen, sodass anhand einer Dauer eines entsprechenden Ladevorgangs und eines zum Aufladen verwendeten Ladestroms auf die Gesamtkapazität und entsprechend auf einen aktuellen Zustand der Batterie geschlossen werden kann.

Um eine vertrauenswürdige und möglichst fälschungssichere Information über einen ermittelten Zustand einer jeweiligen Batterie bereitzustellen, ist erfindungsgemäß vorgesehen, dass durch das vorgestellte Verfahren ermittelte Informationen über die Gesamtkapazität bzw. den aktuellen Zustand der Batterie in ein digitales Zertifikat eingebunden und auf einem Speicher, insbesondere einem zentral verwalteten Cloudspeicher, hinterlegt werden.

Entsprechend kann ein Nutzer jeweilige Informationen über den Zustand der Batterie anhand des Zertifikats an sich und ggf. anhand einer Historie von bereits hinterlegten Zertifikaten bzw. ermittelten Zuständen der Batterie überprüfen.

Zur Erhöhung einer Genauigkeit eines jeweiligen ermittelten Kennwerts eines Zustands einer jeweiligen Batterie kann das vorgestellte Verfahren bzw. ein Entladen und Aufladen der Batterie in mehreren Zyklen wiederholt werden.

Es kann vorgesehen sein, dass die Batterie durch Aktivieren eines Energieverbrauchers des Fahrzeugs und/oder durch bidirektionales Laden entladen wird.

Um den erfindungsgemäß vorgesehenen vorgegebenen Ladezustand zu erreichen bzw. die Batterie vollständig zu entladen, kann ein entsprechendes Fahrzeug soweit wie möglich gefahren werden.

Um ein Risiko eines Stehenbleibens auf einer Fahrbahn aufgrund einer leeren Batterie zu reduzieren, kann ein nicht zum Antreiben des Fahrzeugs vorgesehener Energieverbraucher verwendet werden, um die Batterie in den vorgegebenen Ladezustand zu bringen, während das Fahrzeug steht. Dazu kann bspw. eine Klimaanlage, ein elektrisches Heizsystem, eine Umwälzpumpe oder jeder weitere elektrische Energieverbraucher des Fahrzeugs aktiviert werden.

Alternativ oder zusätzlich zur Aktivierung eines Energieverbrauchers eines Fahrzeugs kann das Fahrzeug dazu konfiguriert werden, elektrische Energie durch ein bidirektionales Ladesystem in ein Stromnetz bzw. einen Energiespeicher einzuspeisen und die Batterie dadurch bis zum dem vorgegebenen Ladezustand zu entladen.

Es kann weiterhin vorgesehen sein, dass das Verfahren durch ein von einer Recheneinheit drahtlos an das Fahrzeug übermitteltes Startsignal gestartet wird.

Um eine direkte Bedienung eines jeweiligen Fahrzeugs zum Ermitteln eines Zustands einer Batterie des Fahrzeugs durch einen Nutzer zu vermeiden, kann das Verfahren aus der Ferne, durch eine von dem Fahrzeug räumlich beabstandete Recheneinheit, wie bspw. ein Smartphone oder einen Computer, gestartet werden. Dazu kann bspw. ein Programm auf einem Computer einer Werkstatt, eine auf einem Smartphone ausgeführte Applikation oder ein Internetportal, indem eine Generierung eines entsprechenden Startsignals erworben werden kann, vorgesehen sein. Ein Startsignal zum Starten des vorgestellten Verfahrens kann direkt von der Recheneinheit an das Fahrzeug übertragen werden oder in Reaktion auf eine Eingabe eines Nutzers auf der Recheneinheit von einem zentralen Verwaltungsserver an das Fahrzeug übertragen werden.

In Reaktion auf einen Empfang eines Startsignals beginnt ein jeweiliges Fahrzeug mit dem Entladen der Batterie des Fahrzeugs.

Es kann weiterhin vorgesehen sein, dass vor dem Laden der Batterie die Batterie für mindestens einen vorgegebenen Zeitraum in einem Ruhezustand belassen wird.

Um einen definierten und entsprechend vergleichbaren Ausgangspunkt zum Laden einer jeweiligen Batterie zu erreichen, kann ein Ruhezeitraum vorgesehen sein, in dem die Batterie nach dem Entladen in einen vorgegebenen Startzustand kommt und relaxiert.

Es kann weiterhin vorgesehen sein, dass unmittelbar vor dem Laden der Batterie die Batterie ein aktueller Zustand der Batterie ermittelt wird.

Um einen Startzustand einer Batterie exakt zu bestimmen und entsprechend auf eine Gesamtkapazität der Batterie zu schließen, kann der Startzustand unmittelbar vor einem Ladevorgang bestimmt werden, indem bspw. eine Zellspannungsmessung durchgeführt wird. Der dadurch ermittelte Startzustand kann mit einem Endzustand nach einem Ladevorgang vergleichen und anhand der Differenz auf einen Zustand der Batterie geschlossen werden.

Es kann weiterhin vorgesehen sein, dass das Zertifikat von einem mit dem Fahrzeug über eine Kommunikationsschnittstelle verbundenen Computer oder einer Recheneinheit des Fahrzeugs erstellt wird.

Um ein möglichst fälschungssicheres Zertifikat zu erstellen, kann ein zentraler und entsprechend gut überwachter Zentralserver verwendet werden. Alternativ kann ein Zertifikat von einem jeweiligen Fahrzeug direkt erzeugt und später bspw. durch Verwendung eines Kryptoschlüssels von einer Sicherheitsinstanz, wie bspw. einer Werkstatt oder einem Zentralserver validiert werden.

Es kann weiterhin vorgesehen sein, dass das Zertifikat auf einer Ausgabeeinheit des Fahrzeugs und/oder einer mobilen Recheneinheit ausgegeben wird.

Um einem Nutzer die Informationen über den Zustand der Batterie eines jeweiligen Fahrzeugs anzuzeigen, kann ein erfindungsgemäß erstelltes Zertifikat auf eine mobile Recheneinheit, wie bspw. ein Smartphone übertragen werden und/oder auf einer Ausgabeeinheit des Fahrzeugs, wie bspw. einem HMI-Display ausgegeben werden. Dabei kann das Zertifikat aus einem Speicher des Fahrzeugs oder von einem Zentralserver geladen werden.

Nachfolgend ist ein beispielhafter Gesamtablauf einer möglichen Ausgestaltung des vorgestellten Verfahren dargestellt;
1. Ein Kunde aktiviert einen Dienst "Zertifikat Gesundheitszustand", bspw. in einer Werkstatt, in einem Online-Store oder in einem in Car App-Shop.
2. Der Dienst wird auf einem Verwaltungsserver aktiviert und ein entsprechendes Fahrzeug mit einem Startbefehl zum Durchführen des vorgestellten Verfahrens versorgt.
3. Das Fahrzeug informiert den Kunden über einen Ablauf des Verfahrens, bspw. per E-Mail oder über eine Applikation auf einem Smartphone.
4. Der Kunde aktiviert einen Start eines Testzyklus im Fahrzeug oder durch einen an das Fahrzeug übermittelten Steuerungsbefehl.
5. Der Kunde erhält einen Hinweis, eine Batterie des Fahrzeugs leer zu fahren oder über bidirektionales Laden zu entleeren.
6. Das Fahrzeug entlädt die Batterie automatisch bis zu auf einen vorgegebenen Wert unter Verwendung nicht antriebsrelevanter Verbraucher, für den Fall, dass der Kunde die Batterie nicht bis zu dem vorgegebenen Wert entladen hat.
7. Das Fahrzeug legt eine definierte Wartezeit ein, damit die Batterie relaxiert bzw. in einen definierten Zustand kommt.
8. Die Batterie wird nach der Wartezeit auf einen aktuellen Ladezustand durch Zellspannungsmessung oder eine weitere Messung physikalischer Eigenschaften der Batterie kalibriert.
9. Das Fahrzeug beginnt einen Ladezyklus mit einem vorgegebenen Ladestrom, der bspw. in Abhängigkeit von einem Zelltyp und/oder einer chemischen Struktur der Batterie gewählt werden kann.
10. Die Batterie wird komplett geladen, insbesondere unter Ignorieren von Kundeneinstellungen des Fahrzeugs.
11. Abschließend wird die Gesamtkapazität der Batterie ermittelt.
12. Die ermittelte Gesamtkapazität wird gesichert und signiert auf dem Verwaltungsserver und/oder in einem Speicher des Fahrzeugs abgelegt.
13. Ein Zertifikat wird ausgestellt und dem Kunden auf einer Ausgabeeinheit ausgegeben.
14. Zur Erhöhung der Genauigkeit können die Ladezyklen optional mehrfach wiederholt werden.

In einem zweiten Aspekt betrifft die vorgestellte Erfindung ein Prüfsystem zum Prüfen eines Zustands einer Batterie in einem Fahrzeug. Das Prüfsystem umfasst eine Recheneinheit. Die Recheneinheit ist dazu konfiguriert, einen Entladebefehl zum Entladen der Batterie bis zu einem vorgegebenen Ladezustand an ein Steuergerät des Fahrzeugs zu übermitteln, einen Ladebefehl zum Laden der Batterie mit einem vorgegebenen Ladestrom bis die Batterie vollständig geladen ist, an das Steuergerät des Fahrzeugs zu übermitteln, eine Gesamtkapazität der Batterie anhand einer Ladezeit und des Ladestroms zu ermitteln, ein signiertes Zertifikat, das die Gesamtkapazität beschreibt, zu erstellen, das Zertifikat in einem Speicher zu sichern und das Zertifikat auf einer Ausgabeeinheit auszugeben.

Das vorgestellte Prüfsystem dient insbesondere zur Durchführung des vorgestellten Verfahrens.

Es kann vorgesehen sein, dass die Recheneinheit ein mit dem Fahrzeug über eine Kommunikationsschnittstelle verbundener Computer oder ein in dem Fahrzeug angeordneter Prozessor ist.

Durch eine Recheneinheit, die mit einem jeweiligen Fahrzeug über eine Kommunikationsschnittstelle verbunden ist, kann eine Vielzahl von Fahrzeugen zur Durchführung des vorgestellten Verfahrens konfiguriert werden, wobei lediglich eine entsprechende Kommunikationsschnittstelle, wie bspw. eine Drahtlosschnittstelle, insbesondere eine Mobilfunkschnittstelle, an einem jeweiligen Fahrzeug erforderlich ist.

Es kann weiterhin vorgesehen sein, dass die Recheneinheit eine Kommunikationsschnittstelle zur Kommunikation mit einer Benutzerschnittstelle eines Nutzers umfasst, durch die die Recheneinheit aktiviert werden kann, um eine mögliche Ausgestaltung des vorgestellten Verfahrens auszuführen.

Es kann weiterhin vorgesehen sein, dass das Prüfsystem einen Sicherheitsserver umfasst, der dazu konfiguriert ist, jeweilige Zertifikate anhand eines Kryptoschlüssels zu überprüfen.

Durch einen Sicherheitsserver kann ein Nutzer, wie bspw. ein Käufer eines Fahrzeugs, ein ihm von einem Verkäufer übermitteltes Zertifikat auf Authentizität prüfen lassen. Dazu sendet der Käufer das Zertifikat an den Sicherheitsserver. Der Sicherheitsserver gleicht einen von dem Zertifikat umfassten Kryptoschlüssel mit einem lokalen Kryptoschlüssel des Sicherheitsservers ab und erzeugt eine Validierungsnachricht. Wenn die Kryptoschlüssel zueinander passen enthält die Validierungsnachricht eine Authentizitätsbestätigung. wenn die Kryptoschlüssel nicht zueinander passen enthält die Validierungsnachricht eine Authentizitätsnegierung.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind.

Dabei können die in den Ansprüchen und in der Beschreibung erwähnten Merkmale jeweils einzeln für sich oder in beliebiger Kombination erfindungswesentlich sein. Es zeigen:
- Fig. 1: eine mögliche Ausgestaltung des vorgestellten Verfahrens,
- Fig. 2: eine mögliche Ausgestaltung des vorgestellten Prüfsystems.

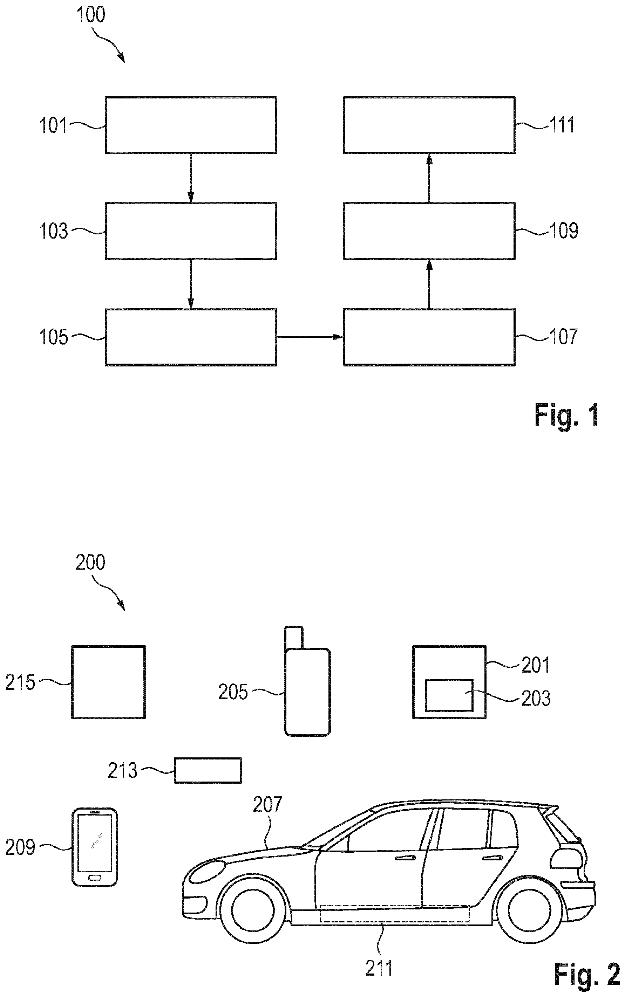

In Fig. 1 ist ein Verfahren 100 dargestellt.

Das Verfahren 100 umfasst einen Entladeschritt 101 zum Entladen der Batterie bis zu einem vorgegebenen Ladezustand, einen Ladeschritt 103 zum Laden der Batterie mit einem vorgegebenen Ladestrom bis die Batterie vollständig geladen ist, einen Ermittlungsschritt 105 zum Ermitteln einer Gesamtkapazität der Batterie anhand einer Ladezeit und des Ladestroms, einen Zertifizierungsschritt 107 zum Erstellen eines signierten Zertifikats, das die Gesamtkapazität beschreibt, einen Sicherungsschritt 109 zum Sichern des Zertifikats in einem Speicher und einen Ausgabeschritt 111 zum Ausgeben des Zertifikats auf einer Ausgabeeinheit.

In Fig. 2 ist ein Prüfsystem 200 dargestellt.

Das Prüfsystem 200 umfasst eine Recheneinheit 201 und eine optionale Kommunikationsschnittstelle 203.

Über die Kommunikationsschnittstelle 203 können Startsignale zum Starten eines Verfahrens, wie bspw. dem Verfahren 100 gemäß Fig. 1 empfangen werden. Alternativ oder zusätzlich kann über die Kommunikationsschnittstelle 203 ein Ausgabesignal, das bspw. ein erzeugtes Zertifikat umfasst, an eine Ausgabeeinheit 205, wie bspw. ein Smartphone, übertragen werden.

Entsprechend kann ein Verkäufer eines Fahrzeugs 207 über sein Smartphone 209 auf ein Internetportal zugreifen, dort eine Operation zum Erzeugen eines Startbefehls erwerben, der das Prüfsystem 200 dazu konfiguriert, das Verfahren 100 gemäß Fig. 1 durchzuführen und ein Zertifikat 213 über einen Zustand einer Batterie 211 des Fahrzeugs 207 zu erstellen.

Das Zertifikat 213 wird einem Käufer auf der Ausgabeeinheit 205, hier dem Smartphone des Käufers, ausgegeben.

Das Zertifikat 213 kann eine digitale Signatur umfassen, anhand derer der Käufer eine vertrauenswürdige Quelle zum Erzeugen des Zertifikats erkennen kann.

Zusätzlich oder alternativ kann der Käufer das Zertifikat 213 an einen Sicherheitsserver 215 übertragen und dort prüfen lassen. Der Sicherheitsserver kann das Zertifikat 213 bspw. unter Verwendung eines von dem Zertifikat 213 umfassten Kryptoschlüssels überprüfen bzw. authentifizieren.

### Bezugszeichenliste

- 100: Verfahren
- 101: Entladeschritt
- 103: Ladeschritt
- 105: Ermittlungsschritt
- 107: Zertifizierungsschritt
- 109: Sicherungsschritt
- 111: Ausgabeschritt
- 200: Prüfsystem
- 201: Recheneinheit
- 203: Kommunikationsschnittstelle
- 205: Ausgabeeinheit
- 207: Fahrzeug
- 209: Smartphone
- 211: Batterie
- 213: Zertifikat
- 215: Sicherheitsserver

## Patentansprüche

1. Verfahren (100) zum Prüfen eines Zustands einer Batterie (211) in einem Fahrzeug (207),
wobei das Verfahren (100) umfasst:
- Entladen (101) der Batterie (211) bis zu einem vorgegebenen Ladezustand,
- Laden (103) der Batterie (211) mit einem vorgegebenen Ladestrom bis die Batterie (211) vollständig geladen ist,
- Ermitteln (105) einer Gesamtkapazität der Batterie (211) anhand einer Ladezeit und des Ladestroms,
- Erstellen (107) eines signierten Zertifikats (213), das die Gesamtkapazität beschreibt,
- Sichern (109) des Zertifikats (213) in einem Speicher,
- Ausgeben (111) des Zertifikats (213) auf einer Ausgabeeinheit (205).

2. Verfahren (100) nach Anspruch 1,
**dadurch gekennzeichnet,**
**dass** die Batterie (211) durch Aktivieren eines Energieverbrauchers des Fahrzeugs (207) und/oder durch bidirektionales Laden entladen wird.

3. Verfahren (100) nach Anspruch 1 oder 2,
**dadurch gekennzeichnet,**
**dass** das Verfahren (100) durch ein von einer Recheneinheit (201) drahtlos an das Fahrzeug (207) übermitteltes Startsignal gestartet wird.

4. Verfahren (100) nach einem der voranstehenden Ansprüche,
**dadurch gekennzeichnet,**
**dass** vor dem Laden der Batterie (211) die Batterie (211) für mindestens einen vorgegebenen Zeitraum in einem Ruhezustand belassen wird.

5. Verfahren (100) nach einem der voranstehenden Ansprüche,
**dadurch gekennzeichnet,**
**dass** unmittelbar vor dem Laden der Batterie (211) ein aktueller Zustand der Batterie (211) ermittelt wird.

6. Verfahren (100) nach einem der voranstehenden Ansprüche,
**dadurch gekennzeichnet,**
**dass** das Zertifikat (213) von einem mit dem Fahrzeug (207) über eine Kommunikationsschnittstelle (203) verbundenen Computer oder einer Recheneinheit (201) des Fahrzeugs erstellt wird.

7. Verfahren (100) nach einem der voranstehenden Ansprüche,
**dadurch gekennzeichnet,**
**dass** das Zertifikat (213) auf einer Ausgabeeinheit des Fahrzeugs (207) und/oder einer mobilen Recheneinheit (205) ausgegeben wird.

8. Prüfsystem (200) zum Prüfen eines Zustands einer Batterie (211) in einem Fahrzeug (207),
wobei das Prüfsystem (200) eine Recheneinheit (201) umfasst, und
wobei die Recheneinheit (201) dazu konfiguriert ist,
einen Entladebefehl zum Entladen der Batterie (211) bis zu einem vorgegebenen Ladezustand an ein Steuergerät des Fahrzeugs (207) zu übermitteln,
einen Ladebefehl zum Laden der Batterie (211) mit einem vorgegebenen Ladestrom bis die Batterie (211) vollständig geladen ist, an das Steuergerät des Fahrzeugs (207) zu übermitteln,
eine Gesamtkapazität der Batterie (211) anhand einer Ladezeit und des Ladestroms zu ermitteln,
ein signiertes Zertifikat (213), das die Gesamtkapazität beschreibt, zu erstellen,
das Zertifikat (213) in einem Speicher zu sichern und das Zertifikat (213) auf einer Ausgabeeinheit (205) auszugeben.

9. Prüfsystem (200) nach Anspruch 8,
**dadurch gekennzeichnet,**
**dass** die Recheneinheit (201) ein mit dem Fahrzeug (207) über eine Kommunikationsschnittstelle (203) verbundener Computer oder ein in dem Fahrzeug (207) angeordneter Prozessor ist.

10. Prüfsystem (200) nach Anspruch 8 oder 9,
**dadurch gekennzeichnet,**
**dass** die Recheneinheit (201) eine Kommunikationsschnittstelle (203) zur Kommunikation mit einer Benutzerschnittstelle eines Nutzers umfasst, durch die die Recheneinheit (201) aktiviert werden kann, um ein Verfahren nach einem der Ansprüche 1 bis 7 auszuführen.

11. Prüfsystem (200) nach einem der Ansprüche 8 bis 10,
**dadurch gekennzeichnet,**
**dass** das Prüfsystem (200) einen Sicherheitsserver (215) umfasst, der dazu konfiguriert ist, jeweilige Zertifikate (213) anhand eines Kryptoschlüssels zu überprüfen.

## Claims

1. Method (100) for testing a state of a battery (211) in a vehicle (207),
wherein the method (100) comprises:
- discharging (101) the battery (211) up to a predetermined state of charge,
- charging (103) the battery (211) using a predetermined charging current until the battery (211) is fully charged,
- determining (105) a total capacity of the battery (211) on the basis of a charging time and the charging current,
- generating (107) a signed certificate (213) which describes the total capacity,
- saving (109) the certificate (213) in a memory,
- outputting (111) the certificate (213) on an output unit (205).

2. Method (100) according to claim 1,
**characterized in that**
the battery (211) is discharged by activating an energy consumer of the vehicle (207) and/or by bidirectional charging.

3. Method (100) according to claim 1 or claim 2,
**characterized in that**
the method (100) is started by a start signal transmitted wirelessly from a computing unit (201) to the vehicle (207).

4. Method (100) according to any of the preceding claims,
**characterized in that,**
before charging the battery (211), the battery (211) is left in an idle state for at least a predetermined period of time.

5. Method (100) according to any of the preceding claims,
**characterized in that**
a present state of the battery (211) is determined immediately before charging the battery (211).

6. Method (100) according to any of the preceding claims,
**characterized in that**
the certificate (213) is created by a computer or a computing unit (201) of the vehicle connected to the vehicle (207) via a communication interface (203).

7. Method (100) according to any of the preceding claims,
**characterized in that**
the certificate (213) is output on an output unit of the vehicle (207) and/or a mobile computing unit (205).

8. Test system (200) for testing a state of a battery (211) in a vehicle (207),
wherein the testing system (200) comprises a computing unit (201), and
wherein the computing unit (201) is configured to
transmit a discharge command to a control device of the vehicle (207) in order to discharge the battery (211) up to a predetermined state of charge,
transmit a charging command to the control unit of the vehicle (207) in order to charge the battery (211) using a predetermined charging current until the battery (211) is fully charged,
determine a total capacity of the battery (211) on the basis of a charging time and the charging current,
create a signed certificate (213) which describes the total capacity,
save the certificate (213) in a memory, and output the certificate (213) on an output unit (205).

9. Test system (200) according to claim 8,
**characterized in that**
the computing unit (201) is a computer connected to the vehicle (207) via a communication interface (203) or is a processor located in the vehicle (207).

10. Test system (200) according to claim 8 or claim 9,
**characterized in that**
the computing unit (201) comprises a communication interface (203) for communicating with a user interface of a user, by means of which the computing unit (201) can be activated in order to carry out a method according to any of claims 1 to 7.

11. Test system (200) according to any of claims 8 to 10,
**characterized in that**
the test system (200) comprises a security server (215) which is configured to verify the relevant certificates (213) using a cryptographic key.

## Revendications

1. Procédé (100) de vérification d'un état d'une batterie (211) dans un véhicule (207),
dans lequel le procédé (100) comprend :
- la décharge (101) de la batterie (211) jusqu'à un niveau de charge prédéfini,
- la charge (103) de la batterie (211) avec un courant de charge prédéfini jusqu'à ce que la batterie (211) soit complètement chargée,
- la détermination (105) d'une capacité totale de la batterie (211) à partir d'un temps de charge et du courant de charge,
- la création (107) d'un certificat signé (213) qui décrit la capacité totale,
- la sauvegarde (109) du certificat (213) dans une mémoire,
- l'émission (111) du certificat (213) sur une unité d'émission (205).

2. Procédé (100) selon la revendication 1,
**caractérisé en ce que**
la batterie (211) est déchargée en activant un consommateur d'énergie du véhicule (207) et/ou par une charge bidirectionnelle.

3. Procédé (100) selon la revendication 1 ou 2,
**caractérisé en ce que**
le procédé (100) est démarré par un signal de démarrage transmis sans fil au véhicule (207) par une unité de calcul (201).

4. Procédé (100) selon l'une des revendications précédentes,
**caractérisé en ce qu'**
avant la charge de la batterie (211), la batterie (211) est laissée dans un état de repos pendant au moins une période de temps prédéfinie.

5. Procédé (100) selon l'une des revendications précédentes,
**caractérisé en ce qu'**
un état actuel de la batterie (211) est déterminé immédiatement avant la charge de la batterie (211).

6. Procédé (100) selon l'une des revendications précédentes,
**caractérisé en ce que**
le certificat (213) est créé par un ordinateur ou une unité de calcul (201) du véhicule, relié(e) au véhicule (207) par l'intermédiaire d'une interface de communication (203).

7. Procédé (100) selon l'une des revendications précédentes,
**caractérisé en ce que**
le certificat (213) est émis sur une unité d'émission du véhicule (207) et/ou sur une unité de calcul mobile (205).

8. Système de vérification (200) pour vérifier un état d'une batterie (211) dans un véhicule (207),
dans lequel le système de vérification (200) comprend une unité de calcul (201), et
dans lequel l'unité de calcul (201) est configurée,
pour transmettre à un appareil de commande du véhicule (207) une instruction de décharge pour décharger la batterie (211) jusqu'à un état de charge prédéfini,
pour transmettre à l'appareil de commande du véhicule (207) une instruction de charge pour charger la batterie (211) avec un courant de charge prédéfini jusqu'à ce que la batterie (211) soit complètement chargée,
pour déterminer une capacité totale de la batterie (211) à partir d'un temps de charge et du courant de charge,
pour créer un certificat signé (213) qui décrit la capacité totale,
pour sauvegarder le certificat (213) dans une mémoire et pour émettre le certificat (213) sur une unité d'émission (205).

9. Système de vérification (200) selon la revendication 8,
**caractérisé en ce que**
l'unité de calcul (201) est un ordinateur relié au véhicule (207) par l'intermédiaire d'une interface de communication (203) ou un processeur agencé dans le véhicule (207).

10. Système de vérification (200) selon la revendication 8 ou 9,
**caractérisé en ce que**
l'unité de calcul (201) comprend une interface de communication (203) pour communiquer avec une interface utilisateur d'un utilisateur, par laquelle l'unité de calcul (201) peut être activée pour mettre en œuvre un procédé selon l'une des revendications 1 à 7.

11. Système de vérification (200) selon l'une des revendications 8 à 10,
**caractérisé en ce que**
le système de vérification (200) comprend un serveur de sécurité (215) qui est configuré pour vérifier des certificats (213) respectifs à l'aide d'une clé cryptographique.
